(19) Europäisches Patentamt
European Patent Office
Office européen des brevets

(11) **EP 2 993 784 A1**

(12) **EUROPEAN PATENT APPLICATION**
published in accordance with Art. 153(4) EPC

(43) Date of publication:
**09.03.2016 Bulletin 2016/10**

(51) Int Cl.:
*H03F 3/60* *(2006.01)*       *H03F 1/48* *(2006.01)*

(21) Application number: **14791833.8**

(22) Date of filing: **04.04.2014**

(86) International application number:
**PCT/JP2014/060018**

(87) International publication number:
**WO 2014/178261 (06.11.2014 Gazette 2014/45)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.04.2013   JP 2013095234**

(71) Applicant: **Mitsubishi Electric Corporation Tokyo 100-8310 (JP)**

(72) Inventors:
• **KUWATA, Eigo**
  **Tokyo 100-8310 (JP)**
• **YAMANAKA, Koji**
  **Tokyo 100-8310 (JP)**
• **KIRIKOSHI, Tasuku**
  **Tokyo 100-8310 (JP)**
• **KAMO, Yoshitaka**
  **Tokyo 100-8310 (JP)**

(74) Representative: **Pfenning, Meinig & Partner mbB Patent- und Rechtsanwälte Theresienhöhe 11a 80339 München (DE)**

(54) **DISTRIBUTED AMPLIFIER**

(57)      The connection intervals of N amplifier blocks 3-1 to 3-N to an input transmission line 1 increase with the distance from a signal input terminal $RF_{in}$, and among the N amplifier blocks 3-1 to 3-N, the input capacitor 4 in an amplifier block 3-n connected to the input transmission line 1 at a more distant side from the signal input terminal $RF_{in}$ has a lower capacitance value $C_n$.

FIG.1

**Description**

TECHNICAL FIELD

The present invention relates to a distributed amplifier with high gain, high output power and wideband characteristics.

BACKGROUND ART

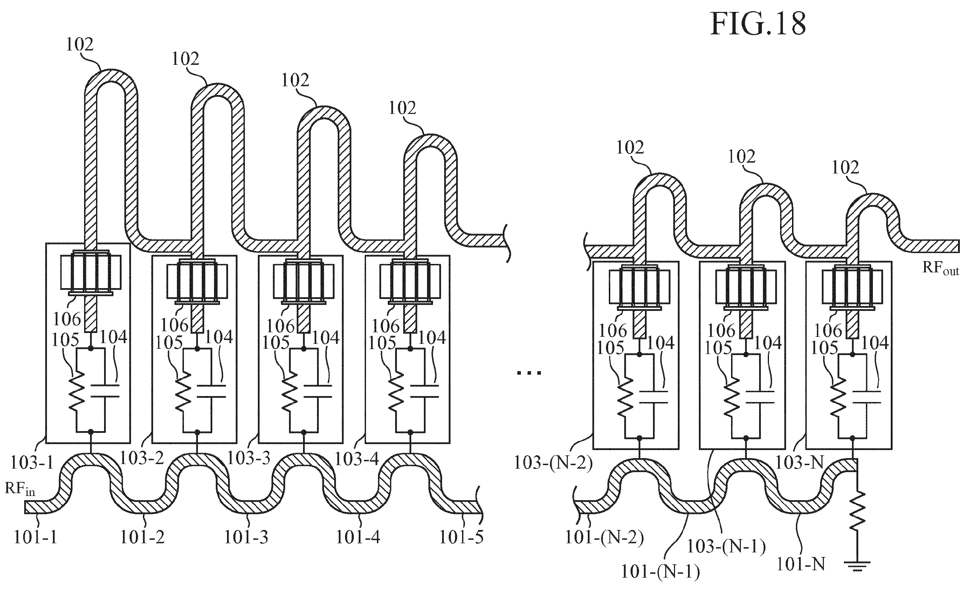

FIG. 18 is a diagram showing a configuration of a distributed amplifier disclosed in the following Non-Patent Document 1.

In FIG. 18, an input transmission line 101 with its first end connected to a signal input terminal $RF_{in}$ is a line for transmitting an RF signal input to the signal input terminal $RF_{in}$.

Incidentally, N amplifier blocks 103-1 to 103-N are connected to the input transmission line 101, and the connection intervals of the N amplifier blocks 103-1 to 103-N to the input transmission line 101 are constant.

More specifically, the lengths of the transmission lines 101-1, 101-2, ..., 101-N between connection positions of the amplifier blocks 103-1 to 103-N to the input transmission line 101 are identical.

An output transmission line 102 with its first end connected to the signal output terminal $RF_{out}$ is a line for transmitting the RF signal amplified by the amplifier blocks 103-1 to 103-N.

The amplifier blocks 103-1 to 103-N, which are connected across the input transmission line 101 and the output transmission line 102, amplify the RF signal input from the input transmission line 101, and output the RF signal after the amplification to the output transmission line 102.

The amplifier blocks 103-1 to 103-N each comprise an input capacitor 104 with its first end connected to the input transmission line 101, a bias resistance 105 connected in parallel with the input capacitor 104, and a transistor 106 with its input terminal connected to a second end of the input capacitor 104 and with its output terminal connected to the output transmission line 102.

As for the distributed amplifier of FIG. 18, the input transmission line 101-n together with the input capacitor 104, the bias resistance 105 and the impedance of the transistor 106 in the amplifier block 103-n are considered as an artificial transmission line, where n = 1, 2, ..., N.

The characteristic impedance of each artificial transmission line is given by the number of stages N of the amplifier blocks 103 and by the impedance of a signal source connected to the amplifier blocks 103.

At this time, the difference between the characteristic impedances necessary for the individual artificial transmission lines is achieved by varying the capacitance values of the input capacitors 104 in the amplifier blocks 103-1 to 103-N.

PRIOR ART DOCUMENT

NON-PATENT DOCUMENT

Non-Patent Document 1: S. Masuda, A. Akasegawa, T. Ohki, K. Makiyama, N. Okamoto, K. Imanishi, T. Kikkawa, and H. Shigematsu, "Over 10W C-Ku Band GaN MMIC Non-uniform Distributed Power Amplifier with Broadband Couplers", 2010 IEEE MTT Symp, pp. 1388-1391, May 2010.

DISCLOSURE OF THE INVENTION

PROBLEMS TO BE SOLVED BY THE INVENTION

With the foregoing configuration, the conventional distributed amplifier provides the characteristic impedance difference necessary for the individual artificial transmission lines by varying the capacitance values of the input capacitors 104 in the amplifier blocks 103-1 to 103-N. However, increasing the number of stages of the amplifier blocks 103 to achieve the high output power, for example, will result in high characteristic impedance of the artificial transmission line at the distant side from the signal input terminal $RF_{in}$. Thus, it is necessary to reduce the capacitance value of the input capacitor 104 of the artificial transmission line at the distant side from the signal input terminal $RF_{in}$, which will reduce the RF voltage amplitude across the input terminal of the transistor 106 and the ground on the artificial transmission line at the distant side from the signal input terminal $RF_{in}$. As a result, the gain of the amplifier blocks 103 reduces, which offers a problem of making it difficult to achieve the high gain and high output at the same time.

The present invention is implemented to solve the foregoing problem. Therefore it is an object of the present invention to provide a distributed amplifier capable of achieving the high gain, high output power and wide bandwidth at the same time.

MEANS FOR SOLVING THE PROBLEM

A distributed amplifier in accordance with the present invention has a configuration in which the connection intervals between a plurality of amplifier blocks to an input transmission line increase with the distance from a signal input terminal, and among the plurality of amplifier blocks, the amplifier block connected to the input transmission line at a more distant side from the signal input terminal has the capacitor with a lower capacitance value.

ADVANTAGES OF THE INVENTION

According to the present invention, it is configured in such a manner that the connection intervals between the plurality of amplifier blocks to the input transmission line increase with the distance from the signal input terminal, and among the plurality of amplifier blocks, the amplifier block connected to the input transmission line at a more distant side from the signal input terminal has the capacitor with a lower capacitance value. Accordingly, it offers an advantage of being able to achieve the high gain, high output power and wide bandwidth at the same time.

BRIEF DESCRIPTION OF THE DRAWINGS

FIG. 1 is a diagram showing a configuration of a distributed amplifier of an embodiment 1 in accordance with the present invention;
FIG. 2 is a diagram showing a configuration of an nth (n =1, 2, ..., N) amplifier block 3-n from the nearest side to the signal input terminal $RF_{in}$ among the amplifier blocks 3-1 to 3-N;
FIG. 3 is a diagram illustrating individual artificial input transmission lines 7-1 to 7-N in the distributed amplifier;
FIG. 4 is an equivalent circuit of the amplifier block 3-n;
FIG. 5 is a table showing characteristic impedances $Z_n$ of the artificial input transmission line in a non-uniform distributed amplifier;
FIG. 6 is a table showing relationships between the input capacitor 4 (capacitance value $C_n$) of the amplifier block 3-n, the inductance component $L_n$ of an input transmission line 1-n, and the characteristic impedance $Z_n$ of the artificial input transmission line 7-n in a conventional non-uniform distributed amplifier;
FIG. 7 is a table showing relationships between the input capacitor 4 (capacitance value $C_n$) of an amplifier block 3-n, the inductance component $L_n$ of an input transmission line 1-n, and the characteristic impedance $Z_n$ of the artificial input transmission line 7-n of the distributed amplifier of the embodiment 1;
FIG. 8 is a table showing relationships between the input capacitor 4 (capacitance value $C_n$) of the amplifier block 3-n, the inductance component $L_n$ of the input transmission line 1-n, the characteristic impedance $Z_n$ of the artificial input transmission line 7-n, and the cutoff frequency of the artificial input transmission line 7-n in the conventional distributed amplifier;
FIG. 9 is a table showing relationships between the input capacitor 4 (capacitance value $C_n$) of the amplifier block 3-n, the inductance component $L_n$ of the input transmission line 1-n, the characteristic impedance $Z_n$ of the artificial input transmission line 7-n, and the cutoff frequency of the artificial input transmission line 7-n in the distributed amplifier of the embodiment 1;
FIG. 10 is a table showing relationships between the input capacitor 4 (capacitance value $C_n$) and the inductance component $L_n$ of the input transmission line 1-n in the conventional distributed amplifier when the resistance value of a bias resistance 5 is 300 Q;
FIG. 11 is a table showing relationships between the input capacitor 4 (capacitance value $C_n$) and the inductance component $L_n$ of the input transmission line 1-n in a distributed amplifier of an embodiment 2 when the resistance value of the bias resistance 5 is 300 Q;
FIG. 12 is a diagram showing difference in the voltage amplitude at the input capacitance $Ct_n$ of a transistor 6 in the amplifier block 3-10;
FIG. 13 is a table showing relationships between the input capacitor 4 (capacitance value $C_n$) of the amplifier block 3-n, the inductance component $L_n$ of the input transmission line 1-n, the characteristic impedance $Z_n$ of the artificial input transmission line 7-n, and the combined capacitance of the input capacitance $Ct_n$ of the transistor 6 and the input capacitor 4 (capacitance value $C_n$) in the conventional distributed amplifier;
FIG. 14 is a table showing relationships between the input capacitor 4 (capacitance value $C_n$) of the amplifier block 3-n, the inductance component $L_n$ of the input transmission line 1-n, the characteristic impedance $Z_n$ of the artificial input transmission line 7-n, and the combined capacitance of the input capacitance $Ct_n$ of the transistor 6 and the input capacitor 4 (capacitance value $C_n$) in a distributed amplifier of an embodiment 3;

FIG. 15 is a table showing relationships between the input capacitor 4 (capacitance value $C_n$) of the amplifier block 3-n, the inductance component $L_n$ of the input transmission line 1-n, and the characteristic impedance $Z_n$ of the artificial input transmission line 7-n in the conventional distributed amplifier;

FIG. 16 is a table showing relationships between the input capacitor 4 (capacitance value $C_n$) of the amplifier block 3-n, the inductance component $L_n$ of the input transmission line 1-n, and the characteristic impedance $Z_n$ of the artificial input transmission line 7-n in a distributed amplifier of an embodiment 4;

FIG. 17 is a diagram showing a configuration of a distributed amplifier of an embodiment 5 in accordance with the present invention; and

FIG. 18 is a diagram showing a configuration of a distributed amplifier disclosed in the Non-Patent Document 1.

BEST MODE FOR CARRYING OUT THE INVENTION

The best mode for carrying out the invention will now be described with reference to the accompanying drawings.

EMBODIMENT 1

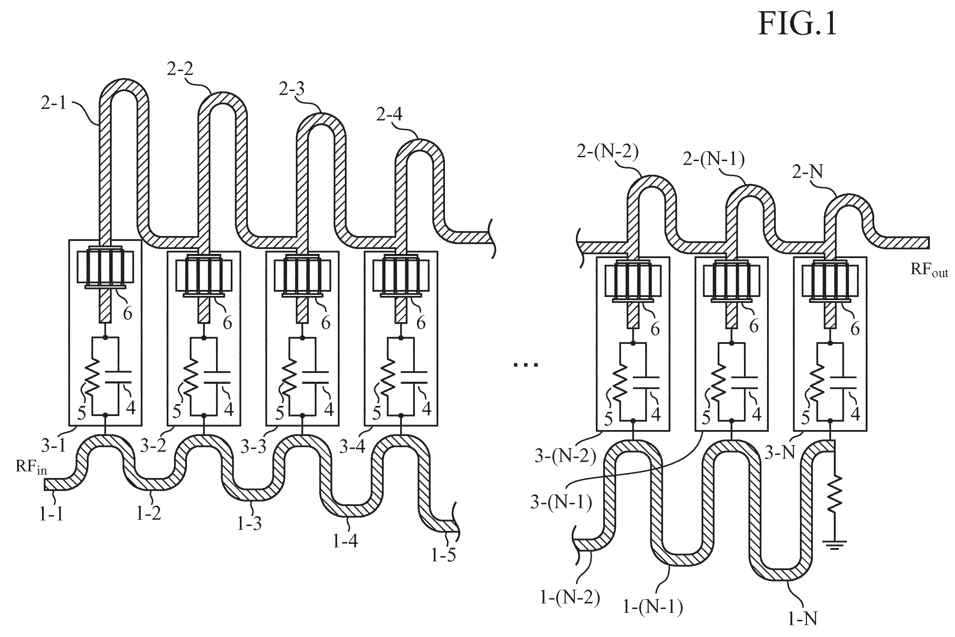

FIG. 1 is a diagram showing a configuration of a distributed amplifier of an embodiment 1 in accordance with the present invention.

In FIG. 1, the input transmission line 1 is a line that has its first end connected to the signal input terminal $RF_{in}$, and transmits an RF signal input to the signal input terminal $RF_{in}$.

Incidentally, N amplifier blocks 3-1 to 3-N are connected to the input transmission line 1 in such a manner that the connection intervals of the N amplifier blocks 3-1 to 3-N to the input transmission line 1 increase with the distance from the signal input terminal $RF_{in}$.

More specifically, when denoting the lengths of the transmission lines 1-1, 1-2, ..., 1-N between the connection positions of the amplifier blocks 3-1 to 3-N to the input transmission line 1 by $Len_{in1}$, $Len_{in2}$, ..., $Len_{inN}$, the following relationships hold.

$$Len_{in1} < Len_{in2} < ... < Len_{inN}$$

The output transmission line 2 is a line that has its first end connected to the signal output terminal $RF_{out}$, and transmits the RF signal amplified by the amplifier blocks 3-1 to 3-N.

Incidentally, N amplifier blocks 3-1 to 3-N are connected to the output transmission line 2, and the connection intervals of the N amplifier blocks 3-1 to 3-N to the output transmission line 2 increase with the distance from the signal output terminal $RF_{out}$.

More specifically, when denoting the lengths of the transmission lines 2-1, 2-2, ..., 2-N between the connection positions of the amplifier blocks 3-1 to 3-N to the output transmission line 2 by $Len_{out1}$, $Len_{out2}$, ..., $Len_{outN}$, the following relationships hold.

$$Len_{out1} > Len_{out2} > ... > Len_{outN}$$

The amplifier blocks 3-1 to 3-N are connected across the input transmission line 1 and the output transmission line 2 (an amplifier block 3 connected to the input transmission line 1 at a nearer side to the signal input terminal $RF_{in}$ is connected to the output transmission line 2 at a more distant side from the signal output terminal $RF_{out}$), amplify the RF signal input from the input transmission line 1, and supply the RF signal after the amplification to the output transmission line 2.

The amplifier blocks 3-1 to 3-N each comprise an input capacitor 4 with its first end connected to the input transmission line 1, a bias resistance 5 connected in parallel with the input capacitor 4, and a transistor 6 with its input terminal (gate terminal, for example) connected to a second end of the input capacitor 4 and with its output terminal (drain terminal, for example) connected to the output transmission line 2.

Incidentally, among the amplifier blocks 3-1 to 3-N, the input capacitor 4 of an amplifier block 3 connected to the input transmission line 1 at a more distant side from the signal input terminal $RF_{in}$ has a lower capacitance value.

More specifically, denoting the capacitance values of the input capacitors 4 of the amplifier blocks 3-1 to 3-N by $C_1$, $C_2$, ..., $C_N$, the following relationships hold.

$$C_1 \; > \; C_2 \; > \; ... \; > \; C_N$$

It is assumed in the present embodiment 1 that the resistance values of the bias resistances 5 are negligible because they are much higher than the absolute values of the impedances calculated from the capacitance values $C_1$, $C_2$, ..., $C_N$ of the input capacitors 4.

Next, the operation will be described.

The factor that decides the gain of the distributed amplifier is the capacitance values $C_1$, $C_2$, ..., $C_N$ of the input capacitors 4 of the amplifier blocks 3-1 to 3-N.

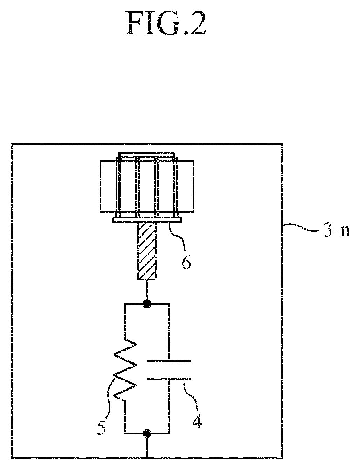

FIG. 2 is a diagram showing a configuration of an nth (n =1, 2, ..., N) amplifier block 3-n from the nearest side to the signal input terminal $RF_{in}$ among the amplifier blocks 3-1 to 3-N.

It is assumed here that the input capacitance of the transistor 6 in the amplifier block 3-n is $Ct_n$, and the capacitance value of the input capacitor 4 in the amplifier block 3-n is $C_n$.

In the present embodiment 1, an artificial input transmission line is constructed to achieve a desired characteristic impedance by considering the combined capacitance of the input capacitance $Ct_n$ of the transistor 6 and the input capacitor 4 (capacitance value $C_n$) in the amplifier block 3-n, and the inductance component of the input transmission line 1-n.

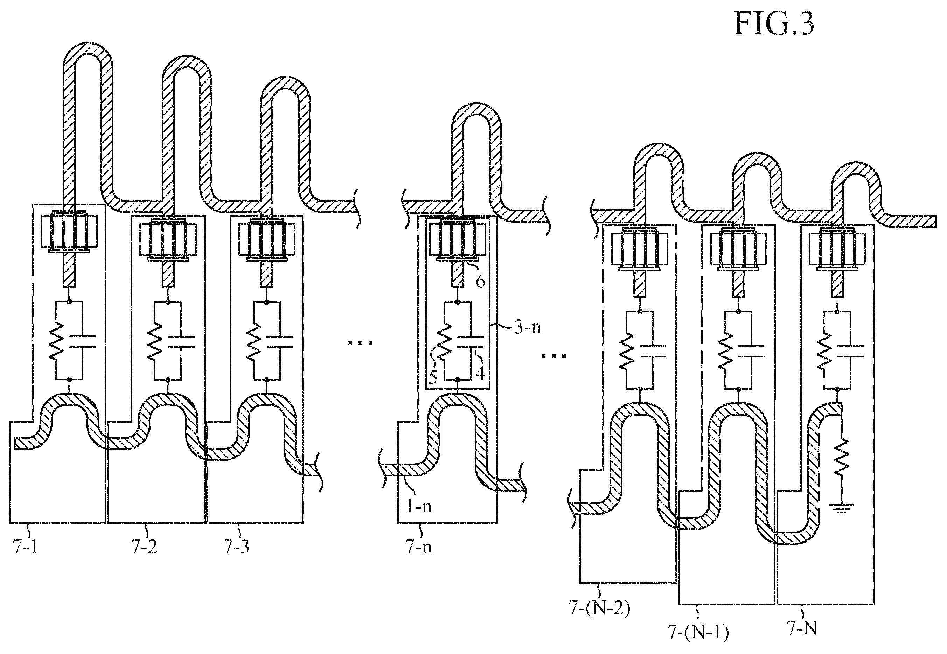

FIG. 3 is a diagram showing the individual artificial input transmission lines 7-1 to 7-N in the distributed amplifier.

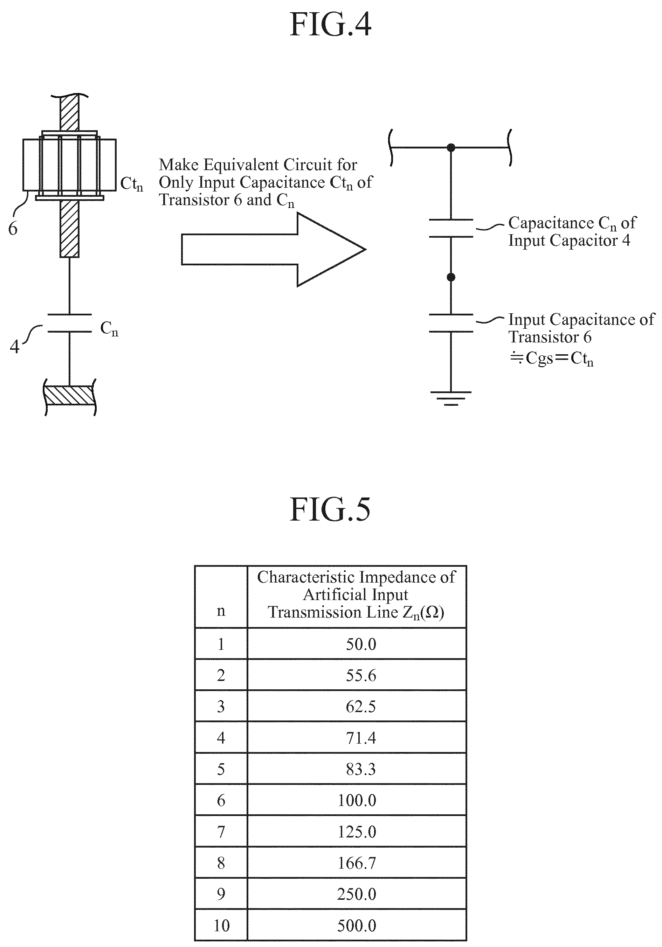

In addition, FIG. 4 is an equivalent circuit of the amplifier block 3-n.

In the equivalent circuit of the amplifier block 3-n in FIG. 4, assume that the input voltage across the two capacitors is $Vin_n$, then the voltage $Vtr_n$ across the input capacitance $Ct_n$ of the transistor 6 is given by the following Expression (1).

$$Vtr_n = Vin_n \times \frac{C_n}{C_n + Ct_n} \qquad (1)$$

It is found from Expression (1) that the voltage $Vtr_n$ across the input capacitance $Ct_n$ of the transistor 6 decreases with the reduction in the capacitance value $C_n$ of the input capacitor 4.

Since the current amplitude (gain) Id of the amplifier block 3-n is determined by the following Expression (2), the voltage $Vtr_n$ across the input capacitance $Ct_n$ of the transistor 6 reduces with the reduction in the capacitance value $C_n$ of the input capacitor 4, thereby reducing the gain of the amplifier block 3-n.

$$Id = g_n \times Vtr_n \qquad (2)$$

In Expression (2), $g_n$ represents transconductance which is a fixed value independent of the transistor 6.

As a high power distributed amplifier, a non-uniform distributed amplifier is common.

Assume that the characteristic impedances of the artificial input transmission lines 7-1, 7-2, ..., 7-N of the non-uniform distributed amplifier are $Z_1$, $Z_2$, ..., $Z_N$, then the characteristic impedance $Z_n$ of the nth artificial input transmission line 7-n is given by the following Expression (3).

$$Z_n = \frac{N \bullet Z_{in}}{1 + N - n} \qquad (3)$$

In Expression (3), $Z_{in}$ is the impedance of the signal source connected to the distributed amplifier.

Here, suppose a non-uniform distributed amplifier with N =10 and $Z_{in}$ = 50 Q, then the characteristic impedances $Z_1$, $Z_2$, ..., $Z_N$ of the artificial input transmission lines 7-1, 7-2, ..., 7-N become as shown in FIG. 5.

From FIG. 5, it is seen that among the artificial input transmission lines 7-1, 7-2, ..., 7-N, an artificial input transmission line 7-n with a higher n (artificial input transmission line 7-n more distant from the signal input terminal $RF_{in}$) has a higher characteristic impedance $Z_n$.

In addition, denoting the inductance component of the input transmission line 1-n by $L_n$, then the characteristic impedance $Z_n$ of the artificial input transmission line 7-n is determined by the inductance component $L_n$ of the input transmission line 1-n, by the input capacitance $Ct_n$ of the transistor 6 and by the input capacitor 4 (capacitance value $C_n$) as shown by the following Expression (4).

$$Z_n = \sqrt{\dfrac{L_n}{\dfrac{C_n \times Ct_n}{C_n + Ct_n}}} \qquad (4)$$

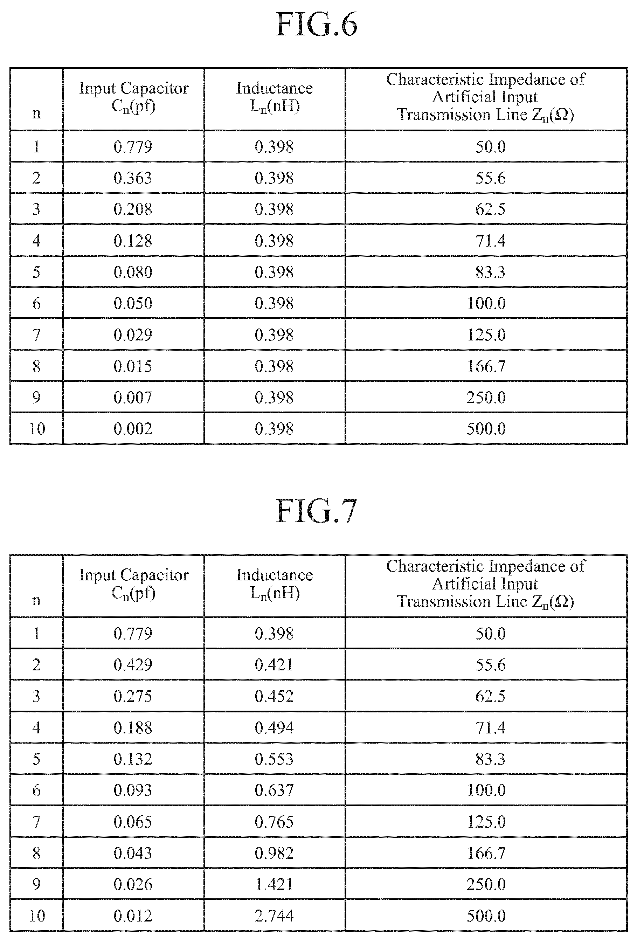

For example, when the input capacitance $Ct_n$ of the transistor 6 is 0.2 pF and the minimum cutoff frequency of the artificial input transmission line 7-n is 20 GHz, then the input capacitor 4 (capacitance value $C_n$) of the amplifier block 3-n of the conventional non-uniform distributed amplifier, the inductance component $L_n$ of the input transmission line 1-n, and the characteristic impedance $Z_n$ of the artificial input transmission line 7-n are as shown in FIG. 6.

It is seen from FIG. 6 that the capacitance value $C_{10}$ of the input capacitor 4 at n = 10 is much lower than the capacitance value $C_1$ of the input capacitor 4 at n = 1.

Accordingly, the gain of the amplifier block 3-10 at n = 10 and the gain of the amplifier block 3-1 at n = 1 have a great difference.

Thus, since the gains of the amplifier blocks 3 distant from the signal input terminal $RF_{in}$ are very low, the conventional distributed amplifier cannot achieve high output power by increasing the number of the transistors 6 beyond a certain number.

In other words, increasing the number of the transistors 6 to achieve the high output power presents a problem of reducing the gain of the distributed amplifier.

In the present embodiment 1, to achieve the high output power and high gain at the same time, the connection intervals of the N amplifier blocks 3-1 to 3-N to the input transmission line 1 are provided in such a manner as to increase with the distance from the signal input terminal $RF_{in}$, and among the N amplifier blocks 3-1 to 3-N, the capacitance values of the input capacitors 4 in the amplifier blocks 3 connected to the input transmission line 1 are set in such a manner as to decrease with the distance from the signal input terminal $RF_{in}$.

More specifically, in the present embodiment 1, the input capacitance $Ct_n$ of the transistor 6 and the input capacitor 4 (capacitance value $C_n$) of the amplifier block 3-n, and the inductance component $L_n$ of the input transmission line 1-n are set in such a manner that the input capacitor 4 (capacitance value $C_n$) of the amplifier block 3-n, the inductance component $L_n$ of the input transmission line 1-n, and the characteristic impedance $Z_n$ of the artificial input transmission line 7-n satisfy the relationships of FIG. 7.

It is seen from FIG. 7 that the capacitance value $C_{10}$ of the input capacitor 4 at n = 10 is six times greater than the capacitance value $C_{10}$ of the input capacitor 4 in the conventional non-uniform distributed amplifier.

By calculating the gain Id of the amplifier block 3-10 at n = 10 by Expression (2) in the present embodiment 1 and in the conventional distributed amplifier, it is seen that the gain Id of the distributed amplifier of the present embodiment 1 is six times higher than the gain Id of the conventional distributed amplifier, thus achieving the high gain.

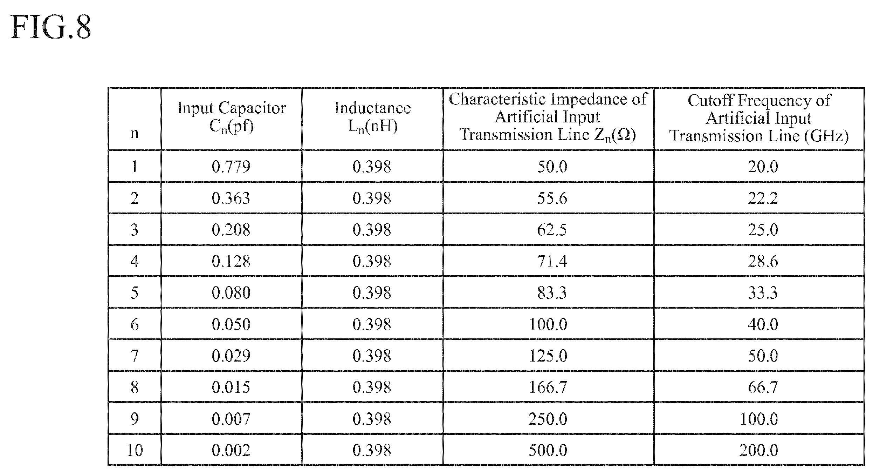

Here, when paying attention to the cutoff frequency of the artificial input transmission line 7-n in the conventional distributed amplifier, the input capacitor 4 of the amplifier block 3-n (capacitance value $C_n$), the inductance component $L_n$ of the input transmission line 1-n, and the characteristic impedance $Z_n$ of the artificial input transmission line 7-n become as shown in FIG. 8.

The artificial input transmission line 7-n closer to the signal input terminal $RF_{in}$ has a lower cutoff frequency, and the artificial input transmission line 7-n more distant from the signal input terminal $RF_{in}$ has a higher cutoff frequency.

At a glance, this seems to be desirable for the distributed amplifier because the higher cutoff frequency has a lower reflection loss. However, since the RF signal power supplied to the signal input terminal $RF_{in}$ is reflected to the signal input terminal $RF_{in}$ side by the artificial input transmission line 7-1 nearest to the signal input terminal $RF_{in}$, it does not reach the artificial input transmission lines 7-2, 7-3, ..., 7-N.

Accordingly, even if the artificial input transmission lines 7-2, 7-3, ..., 7-N have a cutoff frequency higher than the cutoff frequency of the artificial input transmission line 7-1, the RF signal power with a high frequency is not supplied to the transistors 6 of the amplifier blocks 3-2 to 3-N. Thus the gain as the distributed amplifier is lost

Accordingly, it can safely be said that the cutoff frequency of the entire distributed amplifier is determined by the cutoff frequency of the artificial input transmission line 7-1.

Thus, the present embodiment 1 equalizes all the cutoff frequencies of the artificial input transmission lines 7-1, 7-2, ..., 7-N by altering the lengths of the input transmission lines 1-n, and at the same time achieves desired characteristic impedances $Z_n$ of the artificial input transmission line 7-n required of the distributed amplifier.

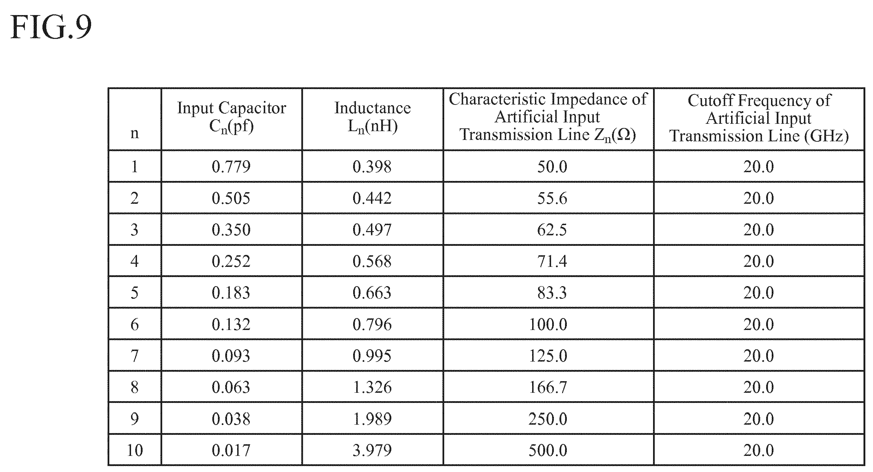

More specifically, the input capacitor 4 (capacitance value $C_n$) of the amplifier block 3-n, the inductance component $L_n$ of the input transmission line 1-n, and the characteristic impedance $Z_n$ of the artificial input transmission line 7-n are set in a manner as to satisfy the relationships of FIG. 9.

It is seen from FIG. 9 that the capacitance value $C_{10}$ of the input capacitor 4 at n = 10, for example, is nine times greater than the capacitance value $C_{10}$ of the input capacitor 4 in the conventional non-uniform distributed amplifier.

By calculating the gain Id of the amplifier block 3-10 at n = 10 by Expression (2) in the present embodiment 1 and in the conventional distributed amplifier, it is seen that the gain Id of the distributed amplifier of the present embodiment 1 is nine times higher than the gain Id of the conventional distributed amplifier, thus achieving a high gain.

In addition, since the cutoff frequency is given by the product of the combined capacitance of the input capacitance $Ct_n$ of the transistor 6 and the input capacitor 4 (capacitance value $C_n$) of the amplifier block 3-n and the inductance component $L_n$ of the input transmission line 1-n, it is found that the cutoff frequencies are identical regardless of the value n in the conditions of FIG. 9.

Here, although an example is shown which has the same cutoff frequency regardless of the value n, if the cutoff frequencies are nearly equal, even if they differ slightly, it can achieve a higher gain than the conventional case which has different cutoff frequencies.

As is clear from the above, according to the present embodiment 1, it is configured in such a manner that the connection intervals of the N amplifier blocks 3-1 to 3-N to the input transmission line 1 increase as they become more distant from the signal input terminal $RF_{in}$, and that among the N amplifier blocks 3-1 to 3-N, the input capacitor 4 in the amplifier block 3-n connected to the input transmission line 1 at the more distant side from the signal input terminal $RF_{in}$ has a lower capacitance value $C_n$. Accordingly, it offers an advantage of being able to achieve a high gain, high output power and wide bandwidth at the same time.

In addition, according to the present embodiment 1, since it is configured in such a manner that the product of the combined capacitance of the input capacitance $Ct_n$ of the transistor 6 and the input capacitor 4 (capacitance value $C_n$) in the nth amplifier block 3-n and the inductance component $L_n$ of the input transmission line 1-n becomes equal to the product of the combined capacitance of the input capacitance $Ct_N$ of the transistor 6 and the input capacitor 4 (capacitance value $C_N$) in the Nth amplifier block 3-N and the inductance component $L_N$ of the input transmission line 1-N. Accordingly, it offers an advantage of being able to equalize the cutoff frequencies of the artificial input transmission lines 7-1, 7-2, ..., 7-N, thereby being able to achieve the higher gain.

Here, even if the products are not perfectly equal, if they are practically equal, the cutoff frequencies of the artificial input transmission lines 7-1, 7-2, ..., 7-N become nearly equal. Thus, the present embodiment 1 offers an advantage of being able to achieve the high gain.

EMBODIMENT 2

Although the embodiment 1 is described on the assumption that the resistance values of the bias resistances 5 are much higher than the absolute values of the impedances calculated from the capacitance values $C_1$, $C_2$, ..., $C_N$ of the input capacitor 4 and hence are negligible, there are some cases where the resistance values of the bias resistances 5 cannot be increased beyond a certain value.

In the present embodiment 2, an example will be described in which the resistance values of the bias resistances 5 cannot be made high.

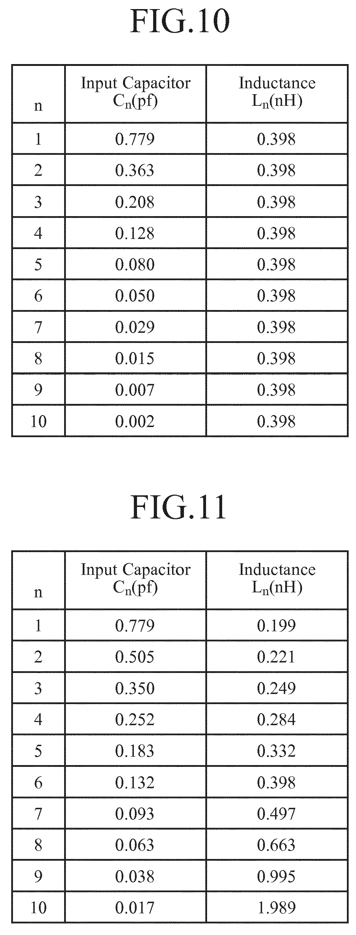

FIG. 10 is a table showing relationships between the input capacitor 4 (capacitance value $C_n$) and the inductance component $L_n$ of the input transmission line 1-n in the conventional distributed amplifier when the resistance value of the bias resistance 5 is 300 Q.

The present embodiment 2, considering the resistance value of the bias resistance 5, sets the connection intervals of the N amplifier blocks 3-1 to 3-N to the input transmission line 1 in such a manner as to increase with the distance from the signal input terminal $RF_{in}$, and among the N amplifier blocks 3-1 to 3-N, it sets the capacitance value $C_n$ of the input capacitor 4 in the amplifier block 3-n, which is connected to the input transmission line 1 at a more distant side from the signal input terminal $RF_{in}$, at a lower value.

More specifically, in order that the input capacitor 4 (capacitance value $C_n$) of the amplifier block 3-n and the inductance component $L_n$ of the input transmission line 1-n may satisfy the relationships of FIG. 11, the present embodiment 2, considering the resistance value of the bias resistance 5, sets the input capacitance $Ct_n$ of the transistor 6, the input capacitor 4 (capacitance value $C_n$) and the resistance value of the bias resistance 5 of the amplifier block 3-n, and the inductance component $L_n$ of the input transmission line 1-n.

The performance difference between the present embodiment 2 and conventional distributed amplifier will be described using an example with n = 10.

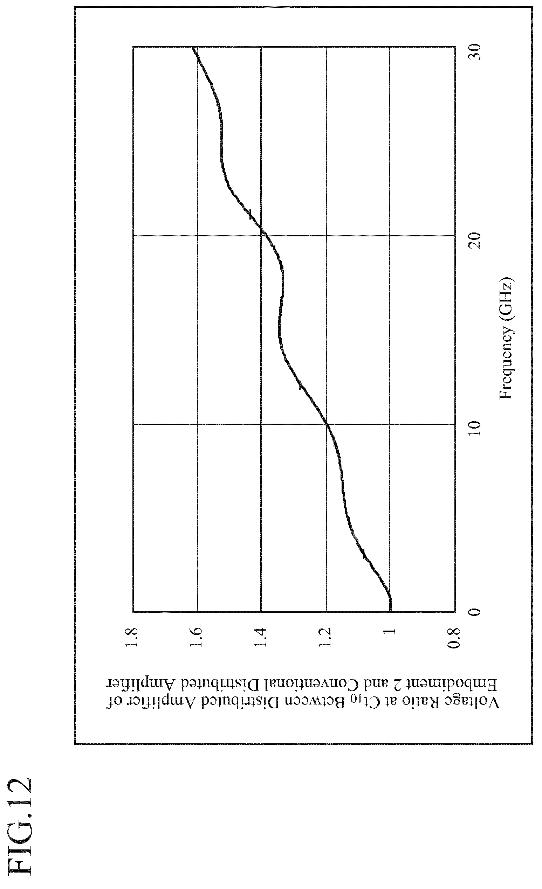

FIG. 12 is a diagram showing the difference of the voltage amplitude across the input capacitance $Ct_n$ of the transistor 6 of the amplifier block 3-10.

FIG. 12 shows values resulting from dividing the voltage amplitude of the distributed amplifier of the present embodiment 2 by the voltage amplitude of the conventional distributed amplifier.

The present embodiment 2, even through the bias resistance 5 exists, sets the connection intervals of the N amplifier blocks 3-1 to 3-N to the input transmission line 1 in such a manner as to increase with the distance from the signal input terminal $RF_{in}$, and considering the bias resistance 5, it gives the parameters in such a manner as to satisfy the required characteristic impedance $Z_n$ of the artificial input transmission line 7-n.

More specifically, to equalize all the cutoff frequencies of the artificial input transmission lines 7-1, 7-2, ..., 7-N when it cannot increase the resistance value of the bias resistance 5, the present embodiment 2 equalizes (or practically equalizes) the product of the combined capacitance of the input capacitance $Ct_n$ of the transistor 6, the input capacitor 4 (capacitance value $C_n$) and the bias resistance 5 in the nth amplifier block 3-n and the inductance component $L_n$ of the input transmission line 1-n to the product of the combined capacitance of the input capacitance $Ct_N$ of the transistor 6, the input capacitor 4 (capacitance value $C_N$) and the bias resistance 5 in the Nth amplifier block 3-N and the inductance component $L_N$ of the input transmission line 1-N.

In this way, as compared with the conventional distributed amplifier, it is seen that the present embodiment 2 can increase the voltage amplitude across the input capacitance $Ct_n$ of the transistor 6, thereby being able to increase the gain Id of the amplifier block 3-n.

As is clear from the above, even when it cannot increase the resistance value of the bias resistance 5, the present embodiment 2 offers an advantage of being able to achieve the high gain, high output power and wide bandwidth as the embodiment 1.

Although the embodiments 1 and 2 suppose that the gate widths of the transistors 6 of the N amplifier blocks 3-1 to 3-N are the same, the gate widths of the individual transistors 6 may differ from each other.

Although the embodiments 1 and 2 do not refer to a concrete configuration of the input transmission line 1-n, the input transmission line 1-n can be comprised of a wire, or a combination of a wire and a transmission line.

Although the embodiments 1 and 2 show an example in which the bias resistance 5 is connected in parallel with the input capacitor 4, the bias resistance 5 can be removed when using the transistor 6 which does not require the bias resistance.

Although the embodiments 1 and 2 show an example in which the transistor 6 and the input capacitor 4 are connected in series, when the input capacitance $Ct_n$ of the transistor 6 is small enough, the input capacitor 4 can be removed (make the capacitance value infinite).

Although the embodiments 1 and 2 show an example in which the amplifier block 3-n comprises the transistor 6 (single transistor), a cascode amplifier can replace the transistor 6, for example.

EMBODIMENT 3

The embodiments 1 and 2 show an example in which the connection intervals of the N amplifier blocks 3-1 to 3-N to the input transmission line 1 increase with the distance from the signal input terminal $RF_{in}$, and among the N amplifier blocks 3-1 to 3-N, the input capacitor 4 in the amplifier block 3-n connected to the input transmission line 1 at the more distant side from the signal input terminal $RF_{in}$ has a lower capacitance value $C_n$. However, a configuration is also possible in which the connection intervals of the N amplifier blocks 3-1 to 3-N to the input transmission line 1 increase with the distant from the signal input terminal $RF_{in}$, and among the N amplifier blocks 3-1 to 3-N, the amplifier block 3-n connected to the input transmission line 1 at the more distant side from the signal input terminal $RF_{in}$ has a lower combined capacitance of the input capacitance $Ct_n$ of the transistor 6 and the input capacitor 4 (capacitance value $C_n$).

More specifically, the combined capacitance of the input capacitance $Ct_n$ of the transistor 6 and the input capacitor 4 (capacitance value $C_n$) in the amplifier block 3-n can be reduced with the value n.

The present embodiment 3 assumes that the resistance value of the bias resistance 5 is much higher than the absolute value of the impedance calculated from the capacitance value $C_1, C_2, ..., C_N$ of the input capacitor 4, and hence negligible.

In the following description, the present embodiment 3 is compared with the conventional distributed amplifier on the assumption that the individual parameters such as the input capacitance $Ct_n$ of the transistor 6 and the cutoff frequency of the amplifier blocks 3-2 to 3-N are the same as those of the embodiment 1 except for the parameters of the transistor 6 in the amplifier block 3-1.

Here, an example will be described in which the gate width of the transistor 6 in the amplifier block 3-1 is 1.5 times greater than the gate width of the transistors 6 in the amplifier blocks 3-2 to 3-N, and hence the input capacitance $Ct_1$ of the transistor 6 of the amplifier block 3-1 is 1.5 times higher than the input capacitance $Ct_n$ of the transistor 6 in the amplifier blocks 3-2 to 3-N.

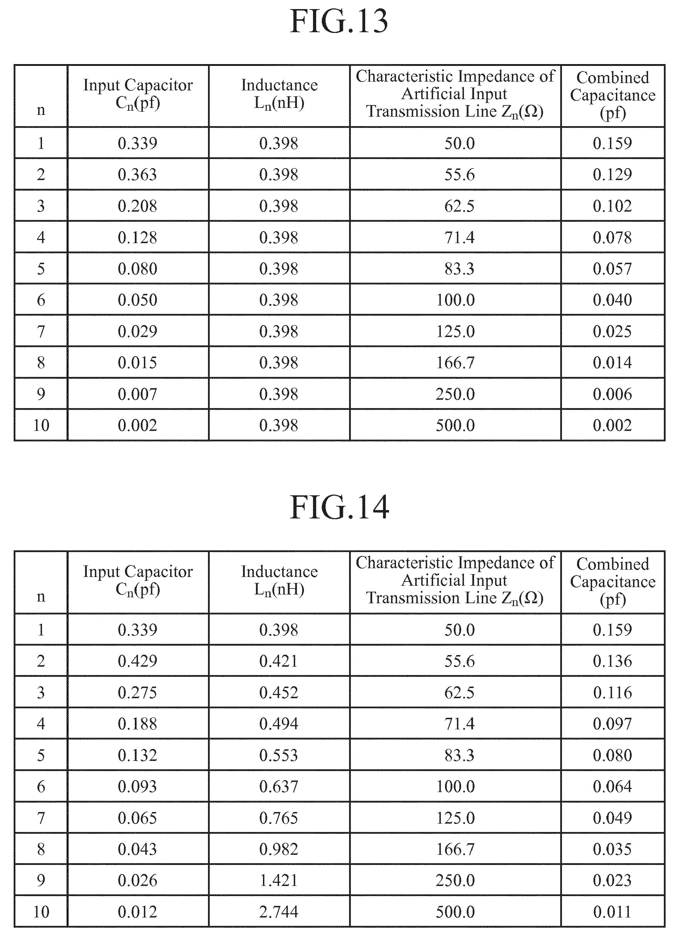

FIG. 13 is a table showing relationships between the input capacitor 4 of the amplifier block 3-n (capacitance value $C_n$), the inductance component $L_n$ of the input transmission line 1-n, the characteristic impedance $Z_n$ of the artificial input transmission line 7-n, and the combined capacitance of the input capacitance $Ct_n$ of the transistor 6 and the input capacitor 4 (capacitance value $C_n$) in the conventional distributed amplifier.

The present embodiment 3 is configured in such a manner that the connection intervals of the N amplifier blocks 3-1 to 3-N to the input transmission line 1 increase with the distance from the signal input terminal $RF_{in}$, and among the N amplifier blocks 3-1 to 3-N, the amplifier block 3-n connected to the input transmission line 1 at a more distant side from the signal input terminal $RF_{in}$ has a lower combined capacitance of the input capacitance $Ct_n$ of the transistor 6 and the input capacitor 4 (capacitance value $C_n$).

More specifically, the present embodiment 3 sets the input capacitance $Ct_n$ of the transistor 6 and the input capacitor 4 (capacitance value $C_n$) of the amplifier block 3-n and the inductance component $L_n$ of the input transmission line 1-n in such a manner that the input capacitor 4 (capacitance value $C_n$) of the amplifier block 3-n, the inductance component $L_n$ of the input transmission line 1-n, the characteristic impedance $Z_n$ of the artificial input transmission line 7-n, and the combined capacitance of the input capacitance $Ct_n$ of the transistor 6 and the input capacitor 4 (capacitance value $C_n$) satisfy the relationships of FIG. 14.

It is seen from FIG. 13 and FIG. 14 that in the distributed amplifier of the present embodiment 3, the capacitance value $C_{10}$ of the input capacitor 4 at n = 10 is six times higher than the capacitance value $C_{10}$ of the input capacitor 4 in the conventional distributed amplifier, for example.

By calculating the gain Id of the amplifier block 3-10 at n = 10 according to Expression (2) in the present embodiment 3 and in the conventional distributed amplifier, it is seen that the gain Id of the distributed amplifier of the present embodiment 3 is six times higher than the gain Id of the conventional distributed amplifier, and that the high gain is achieved.

Thus, the present embodiment 3 can increase the gain of the distributed amplifier even if the number of stages of the amplifier blocks 3 increases. Consequently, it offers an advantage of being able to achieve the high gain, high output power and wide bandwidth at the same time as the embodiment 1.

Although the present embodiment 3 shows an example in which the gate width of the transistor 6 in the amplifier block 3-1 is wider than the gate width of the transistors 6 in the amplifier blocks 3-2 to 3-N, a combination of the gate widths of the transistors 6 in the amplifier blocks 3-1 to 3-N can be varied.

Although the present embodiment 3 does not refer to a concrete configuration of the input transmission line 1-n, the input transmission line 1-n can be comprised of a wire, or a combination of a wire and a transmission line.

Although the present embodiment 3 shows an example in which the bias resistance 5 is connected in parallel with the input capacitor 4, the bias resistance 5 can be removed when using the transistor 6 which does not require the bias resistance. In addition, the resistance values of the bias resistances 5 of the amplifier blocks 3-1 to 3-N may differ from each other.

Although the present embodiment 3 shows an example in which the transistor 6 and the input capacitor 4 are connected in series, when the input capacitance $Ct_n$ of the transistor 6 is small enough, the input capacitor 4 can be removed (make the capacitance value infinite).

Although the present embodiment 3 shows an example in which the amplifier block 3-n comprises the transistor 6 (single transistor), a cascode amplifier can replace the transistor 6, for example.

EMBODIMENT 4

Although the embodiment 1 shows an example in which the product of the combined capacitance of the input capacitance $Ct_n$ of the transistor 6 and the input capacitor 4 (capacitance value $C_n$) in the nth amplifier block 3-n and the inductance component $L_n$ of the input transmission line 1-n is equal to the product of the combined capacitance of the input capacitance $Ct_N$ of the transistor 6 and the input capacitor 4 (capacitance value $C_N$) in the Nth amplifier block 3-N and the inductance component $L_N$ of the input transmission line 1-N, a configuration is also possible in which the product of the combined capacitance of the input capacitance $Ct_n$ of the transistor 6, the input capacitor 4 (capacitance value $C_n$) in the nth amplifier block 3-n and the capacitance component $Cp_n$ of the input transmission line 1-n and the inductance component $L_n$ of the input transmission line 1-n is equal (or practically equal) to the product of the combined capacitance of the input capacitance $Ct_N$ of the transistor 6, the input capacitor 4 (capacitance value $C_N$) in the Nth amplifier block 3-N and the capacitance component $Cp_N$ of the input transmission line 1-N and the inductance component $L_N$ of the input transmission line 1-N.

In the present embodiment 4, the resistance value of the bias resistance 5 is assumed to be much higher than the absolute value of the impedance calculated from the capacitance value $C_1$ , $C_2$, ..., $C_N$ of the input capacitor 4, and hence negligible.

In the following description, the present embodiment 4 is compared with the conventional distributed amplifier on the assumption that the parameters of the transistor 6 of the amplifier block 3-1 and the like are the same as those of the embodiment 1.

It is supposed, however, that the capacitance components $Cp_1$ to $Cp_N$ of the input transmission lines 1-1 to 1-N are 0.01 pF.

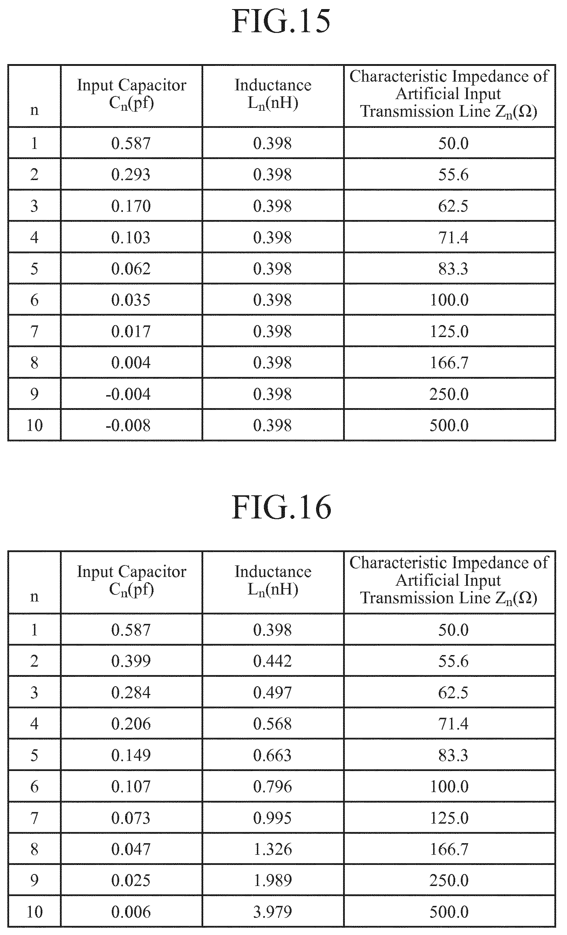

FIG. 15 is a table showing relationships between the input capacitor 4 (capacitance value $C_n$) of the amplifier block 3-n, the inductance component $L_n$ of the input transmission line 1-n, and the characteristic impedance $Z_n$ of the artificial input transmission line 7-n in the conventional distributed amplifier.

In FIG. 15, paying attention to the input capacitor 4 (capacitance value $C_n$), the capacitance required becomes negative at n > 9. It is obvious that a negative capacitance component cannot be created. Accordingly, the conventional distributed amplifier has a limit of eight in the number of transistors 6 under the parameters of the transistors 6 set.

In contrast, the present embodiment 4 sets in such a manner that the connection intervals of the N amplifier blocks 3-1 to 3-N to the input transmission line 1 increase with the distance from the signal input terminal $RF_{in}$, and that the product of the combined capacitance of the input capacitance $Ct_n$ of the transistor 6, the input capacitor 4 (capacitance value $C_n$) in the nth amplifier block 3-n and the capacitance component $Cp_n$ of the input transmission line 1-n and the inductance component $L_n$ of the input transmission line 1-n is equal (or practically equal) to the product of the combined capacitance of the input capacitance $Ct_N$ of the transistor 6, the input capacitor 4 (capacitance value $C_N$) in the Nth amplifier block 3-N and the capacitance component $Cp_N$ of the input transmission line 1-N and the inductance component $L_N$ of the input transmission line 1-N.

By thus setting, the present embodiment 4 can satisfy the relationships shown in FIG. 16 between the input capacitor 4 of the amplifier block 3-n (capacitance value $C_n$), the inductance component $L_n$ of the input transmission line 1-n, and the characteristic impedance $Z_n$ of the artificial input transmission line 7-n.

This makes it possible to prevent the capacitance from becoming negative even at n > 9, and to take a feasible positive capacitance. Accordingly, the present embodiment 4 can implement 10 in the number of transistors 6.

For example, paying attention to the input capacitor 4 (capacitance value $C_8$) of n = 8, it is found that the distributed amplifier of the present embodiment 4 has the capacitance value 12 times higher than the conventional distributed amplifier.

By calculating the gain Id of the amplifier block 3-10 at n = 8 according to Expression (2) in the present embodiment 4 and the conventional distributed amplifier, it is seen that the gain Id of the distributed amplifier of the present embodiment 4 is 12 times higher than the gain Id of the conventional distributed amplifier, and that the high gain is achieved.

Thus, the present embodiment 4 can increase the gain of the distributed amplifier even if the number of stages of the amplifier blocks 3 increases. Consequently, it offers an advantage of being able to achieve the high gain, high output power and wide bandwidth at the same time as the embodiment 1.

Incidentally, even when the same gain as that of the conventional distributed amplifier is enough, since the distributed amplifier of the present embodiment 4 can increase the number of transistors as compared with the conventional distributed amplifier, it can achieve higher output power.

Although the present embodiment 4 supposes that the gate widths of the transistors 6 of the N amplifier blocks 3-1 to 3-N are the same, the gate widths of the individual transistors 6 may differ from each other.

Although the present embodiment 4 does not refer to a concrete configuration of the input transmission line 1-n, the input transmission line 1-n can be comprised of a wire, or a combination of a wire and a transmission line.

Although the present embodiment 4 shows an example in which the bias resistance 5 is connected in parallel with the input capacitor 4, the bias resistance 5 can be removed when using the transistor 6 which does not require the bias resistance.

Although the present embodiment 4 shows an example in which the transistor 6 and the input capacitor 4 are connected in series, when the input capacitance $Ct_n$ of the transistor 6 is small enough, the input capacitor 4 can be removed (make the capacitance value infinite).

Although the present embodiment 4 shows an example in which the amplifier block 3-n comprises the transistor 6 (single transistor), a cascode amplifier can replace the transistor 6, for example.

EMBODIMENT 5

The embodiment 1 shows an example that determines the characteristic impedance $Z_n$ of the artificial input transmission line 7-n from the inductance component $L_n$ of the input transmission line 1-n, the input capacitance $Ct_n$ of the transistor 6 and the input capacitor 4 (capacitance value $C_n$) as shown in the foregoing Expression (4).

To put it in a simpler way based on Expression (4), to obtain the characteristic impedance $Z_n$ and to increase the capacitance value $C_n$ at the same time, the present embodiment 5 increases the inductance component $L_n$ of the input transmission line 1-n. This enables the distributed amplifier to achieve the high gain, high output power and wide bandwidth.

In the present embodiment 5, an example will be described in which an inductance parameter is added to Expression (4).

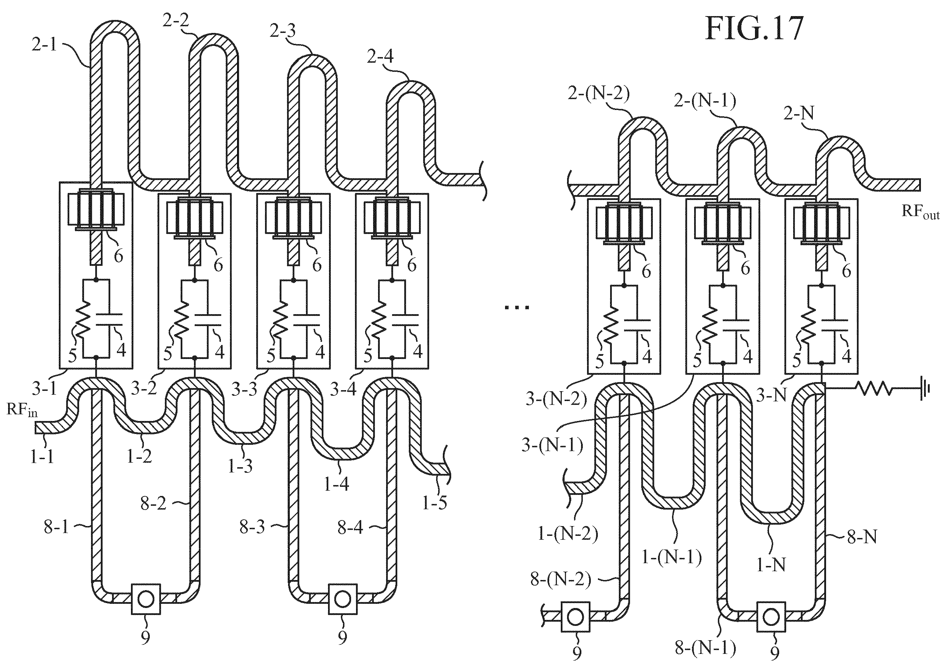

FIG. 17 is a diagram showing a configuration of a distributed amplifier of the embodiment 5 in accordance with the present invention.

Short stubs 8-1 to 8-N are parallel inductors which have their first ends connected to connections of the amplifier blocks 3-1 to 3-N to the input transmission lines 1-1 to 1-N and their second ends connected to via holes 9.

The via holes 9 are grounded.

Assume here that the inductance components of the short stubs 8-1 to 8-N are $Ls_1$ to $Ls_N$, then Expression (4) can be rewritten to the following Expression (5). It differs from Expression (4) in that it has a term of the inductance component $Ls_n$ in the denominator.

$$Z_n = \sqrt{\frac{L_n}{\dfrac{C_n \times Ct_n}{C_n + Ct_n} - \dfrac{1}{\omega^2 Ls_n}}} \qquad\qquad (5)$$

As shown in Expression (1) and Expression (2), an increase of the capacitance value $C_n$ enables improving the gain of the amplifier block 3-n, thereby being able to improve the gain of the distributed amplifier.

It is seen from Expression (5) that giving the small inductance component $Ls_n$ of the short stub 8-n can increase the capacitance value $C_n$ without varying the values of the input capacitance $Ct_n$ of the transistor 6 and the characteristic impedance $Z_n$ of the artificial input transmission line 7-n.

Accordingly, the distributed amplifier of the present embodiment 5 can improve the gain of the individual amplifier blocks, thereby being able to improve the gain of the distributed amplifier.

In the present embodiment 5, the short stubs 8-1 to 8-N which are parallel inductors are added to the distributed amplifier of the embodiment 1.

In this case, it is configured in such a manner that the product of the combined capacitance of the input capacitance $Ct_n$ of the transistor 6 and the input capacitor 4 (capacitance value $C_n$) in the nth amplifier block 3-n and the combined inductance of the short stub 8-n (parallel inductor) connected to the nth amplifier block 3-n and inductance component $L_n$ of the input transmission line 1-n becomes equal (or practically equal) to the product of the combined capacitance of the input capacitance $Ct_N$ of the transistor 6 and the input capacitor 4 (capacitance value $C_N$) in the Nth amplifier block 3-N and the combined inductance of the short stub 8-N (parallel inductor) connected to the Nth amplifier block 3-N and the inductance component $L_N$ of the input transmission line 1-N.

This makes it possible to equalize the cutoff frequencies of the artificial input transmission lines 7-1, 7-2, ..., 7-N, which offers an advantage of being able to achieve a higher gain.

Although the present embodiment 5 shows an example that adds the short stubs 8-1 to 8-N which are parallel inductors to the distributed amplifier of the embodiment 1, a configuration is also possible which adds the short stubs 8-1 to 8-N which are parallel inductors to the distributed amplifier of the embodiment 2.

In this case, it is configured in such a manner that the product of the combined capacitance of the input capacitance $Ct_n$ of the transistor 6, the input capacitor 4 (capacitance value $C_n$) and the bias resistance 5 in the nth amplifier block 3-n and the combined inductance of the short stub 8-n (parallel inductor) connected to the nth amplifier block 3-n and the inductance component $L_n$ of the input transmission line 1-n becomes equal (or practically equal) to the product of the combined capacitance of the input capacitance $Ct_N$ of the transistor 6, the input capacitor 4 (capacitance value $C_N$) and the bias resistance 5 in the Nth amplifier block 3-N and the combined inductance of the short stub 8-N (parallel inductor) connected to the Nth amplifier block 3-N and the inductance component $L_N$ of the input transmission line 1-N.

In addition, in the present embodiment 5, a configuration is also possible which adds the short stubs 8-1 to 8-N which are parallel inductors to the distributed amplifier of the embodiment 3 or 4.

In this case, it is configured in such a manner that the product of the combined capacitance of the input capacitance $Ct_n$ of the transistor 6, the input capacitor 4 (capacitance value $C_n$) in the nth amplifier block 3-n and the $Cp_n$ of the input transmission line 1-n and the combined inductance of the short stub 8-n (parallel inductor) connected to the nth amplifier block 3-n and the inductance component $L_n$ of the input transmission line 1-n becomes equal (or practically equal) to the product of the combined capacitance of the input capacitance $Ct_N$ of the transistor 6, the input capacitor 4 (capacitance value $C_N$) in the Nth amplifier block 3-N and the $Cp_N$ of the input transmission line 1-N and the combined inductance of the short stub 8-N (parallel inductor) connected to the Nth amplifier block 3-N and the inductance component $L_N$ of the input transmission line 1-N.

Incidentally, it is to be understood that a free combination of the individual embodiments, variations of any components of the individual embodiments or removal of any components of the individual embodiments is possible within the scope of the present invention.

INDUSTRIAL APPLICABILITY

The present invention is suitably applied to a distributed amplifier that has to achieve the high gain, high output power and wide bandwidth at the same time.

DESCRIPTION OF REFERENCE SYMBOLS

1-1 to 1-N input transmission line; 2-1 to 2-N output transmission line; 3-1 to 3-N amplifier block; 4 input capacitor; 5 bias resistance; 6 transistor; 7-1 to 7-N artificial input transmission line; 8-1 to 8-N short stub (parallel inductor); 9 via

EP 2 993 784 A1

hole; 101-1 to 101-N input transmission line; 102 output transmission line; 103-1 to 103-N amplifier block; 104 input capacitor; 105 bias resistance; 106 transistor.

**Claims**

1. A distributed amplifier comprising:

   an input transmission line with its first end connected to a signal input terminal;
   an output transmission line with its first end connected to a signal output terminal; and
   a plurality of amplifier blocks each comprising a capacitor with its first end connected to the input transmission line, and a transistor with its input terminal connected to a second end of the capacitor and with its output terminal connected to the output transmission line, wherein
   among the plurality of amplifier blocks, the amplifier block connected to the input transmission line at a nearer side to the signal input terminal is connected to the output transmission line at a more distant side from the signal output terminal, and wherein
   connection intervals between the plurality of amplifier blocks to the input transmission line increase with a distance from the signal input terminal, and among the plurality of amplifier blocks, the amplifier block connected to the input transmission line at a more distant side from the signal input terminal has the capacitor with a lower capacitance value.

2. The distributed amplifier according to claim 1, wherein

   as for the input transmission line to which N amplifier blocks are connected;
   when designating the transmission line between a position at which the nth (n=1, 2, ..., N) amplifier block from a nearest side to the signal input terminal is connected and a position at which the (n+1) th amplifier block is connected by $TL_{n+1}$, then;
   the product of a combined capacitance of the input capacitance of the transistor and the capacitor in the nth amplifier block and an inductance component of the transmission line $TL_n$ is equal to;
   the product of a combined capacitance of the input capacitance of the transistor and the capacitor in the Nth amplifier block and an inductance component of the transmission line $TL_N$.

3. The distributed amplifier according to claim 1, further comprising:

   a plurality of parallel inductors, each of which has its first end connected to a connection of the amplifier block and the input transmission line, and has its second end grounded.

4. The distributed amplifier according to claim 3, wherein

   as for the input transmission line to which N amplifier blocks are connected;
   when designating the transmission line between a position at which the nth (n=1, 2, ..., N) amplifier block from a nearest side to the signal input terminal is connected and a position at which the (n+1) th amplifier block is connected by $TL_{n+1}$, then;
   the product of a combined capacitance of the input capacitance of the transistor and the capacitor in the nth amplifier block and a combined inductance of the parallel inductor connected to the nth amplifier block and an inductance component of the transmission line $TL_n$ is equal to;
   the product of a combined capacitance of the input capacitance of the transistor and the capacitor in the Nth amplifier block and a combined inductance of the parallel inductor connected to the Nth amplifier block and an inductance component of the transmission line $TL_N$.

5. A distributed amplifier comprising:

   an input transmission line with its first end connected to a signal input terminal;
   an output transmission line with its first end connected to a signal output terminal; and
   a plurality of amplifier blocks each comprising a capacitor with its first end connected to the input transmission line, a transistor with its input terminal connected to a second end of the capacitor and with its output terminal connected to the output transmission line, and a resistor connected in parallel with the capacitor, wherein
   among the plurality of amplifier blocks, the amplifier block connected to the input transmission line at a nearer side to the signal input terminal is connected to the output transmission line at a more distant side from the signal output terminal, and wherein

connection intervals between the plurality of amplifier blocks to the input transmission line increase with a distance from the signal input terminal, and among the plurality of amplifier blocks, the amplifier block connected to the input transmission line at a more distant side from the signal input terminal has the capacitor with a lower capacitance value.

6.  The distributed amplifier according to claim 5, wherein

as for the input transmission line to which N amplifier blocks are connected;
when designating the transmission line between a position at which the nth (n=1, 2, ..., N) amplifier block from a nearest side to the signal input terminal is connected and a position at which the (n+1) th amplifier block is connected by $TL_{n+1}$, then;
the product of a combined capacitance of the input capacitance of the transistor, the capacitor and the resistor in the nth amplifier block and an inductance component of the transmission line $TL_n$ is equal to;
the product of a combined capacitance of the input capacitance of the transistor, the capacitor and the resistor in the Nth amplifier block and an inductance component of the transmission line $TL_N$.

7.  The distributed amplifier according to claim 5, further comprising:

a plurality of parallel inductors, each of which has its first end connected to a connection of the amplifier block and the input transmission line, and has its second end grounded.

8.  The distributed amplifier according to claim 7, wherein

as for the input transmission line to which N amplifier blocks are connected;
when designating the transmission line between a position at which the nth (n=1, 2, ..., N) amplifier block from a nearest side to the signal input terminal is connected and a position at which the (n+1) th amplifier block is connected by $TL_{n+1}$, then;
the product of a combined capacitance of the input capacitance of the transistor, the capacitor and the resistor in the nth amplifier block and a combined inductance of the parallel inductor connected to the nth amplifier block and an inductance component of the transmission line $TL_n$ is equal to;
the product of a combined capacitance of the input capacitance of the transistor, the capacitor and the resistor in the Nth amplifier block and a combined inductance of the parallel inductor connected to the Nth amplifier block and an inductance component of the transmission line $TL_N$.

9.  A distributed amplifier comprising:

an input transmission line with its first end connected to a signal input terminal;
an output transmission line with its first end connected to a signal output terminal; and
a plurality of amplifier blocks each comprising a capacitor with its first end connected to the input transmission line, and a transistor with its input terminal connected to a second end of the capacitor and with its output terminal connected to the output transmission line, wherein
among the plurality of amplifier blocks, the amplifier block connected to the input transmission line at a nearer side to the signal input terminal is connected to the output transmission line at a more distant side from the signal output terminal, and wherein
connection intervals between the plurality of amplifier blocks to the input transmission line increase with a distance from the signal input terminal, and among the plurality of amplifier blocks, the amplifier block connected to the input transmission line at a more distant side from the signal input terminal has a lower combined capacitance of the input capacitance of the transistor and the capacitor.

10. The distributed amplifier according to claim 9, wherein
as for the input transmission line to which N amplifier blocks are connected;
when designating the transmission line between a position at which the nth (n=1, 2, ..., N) amplifier block from a nearest side to the signal input terminal is connected and a position at which the (n+1) th amplifier block is connected by $TL_{n+1}$, then;
the product of a combined capacitance of the input capacitance of the transistor, the capacitor in the nth amplifier block and a capacitance component of the transmission line $TL_n$ and an inductance component of the transmission

line $TL_n$ is equal to;

the product of a combined capacitance of the input capacitance of the transistor, the capacitor in the Nth amplifier block and a capacitance component of the transmission line $TL_N$ and an inductance component of the transmission line $TL_N$.

11. The distributed amplifier according to claim 9, further comprising:

a plurality of parallel inductors, each of which has its first end connected to a connection of the amplifier block and the input transmission line, and has its second end grounded.

12. The distributed amplifier according to claim 11, wherein
as for the input transmission line to which N amplifier blocks are connected;
when designating the transmission line between a position at which the nth (n=1, 2, ..., N) amplifier block from a nearest side to the signal input terminal is connected and a position at which the (n+1) th amplifier block is connected by $TL_{n+1}$, then;
the product of a combined capacitance of the input capacitance of the transistor, the capacitor in the nth amplifier block and a capacitance component of the transmission line $TL_n$ and a combined inductance of the parallel inductor connected to the nth amplifier block and an inductance component of the transmission line $TL_n$ is equal to;
the product of a combined capacitance of the input capacitance of the transistor, the capacitor in the Nth amplifier block and a capacitance component of the transmission line $TL_N$ and a combined inductance of the parallel inductor connected to the nth amplifier block and an inductance component of the transmission line $TL_N$.

FIG.1

# FIG.2

FIG.3

# FIG.4

Make Equivalent Circuit for Only Input Capacitance $Ct_n$ of Transistor 6 and $C_n$

$Ct_n$

6

$C_n$

4

Capacitance $C_n$ of Input Capacitor 4

Input Capacitance of Transistor 6
$\fallingdotseq Cgs = Ct_n$

# FIG.5

| n | Characteristic Impedance of Artificial Input Transmission Line $Z_n(\Omega)$ |
|---|---|
| 1 | 50.0 |
| 2 | 55.6 |
| 3 | 62.5 |
| 4 | 71.4 |
| 5 | 83.3 |
| 6 | 100.0 |
| 7 | 125.0 |
| 8 | 166.7 |
| 9 | 250.0 |
| 10 | 500.0 |

# FIG.6

| n | Input Capacitor $C_n$(pf) | Inductance $L_n$(nH) | Characteristic Impedance of Artificial Input Transmission Line $Z_n$($\Omega$) |
|---|---|---|---|
| 1 | 0.779 | 0.398 | 50.0 |
| 2 | 0.363 | 0.398 | 55.6 |
| 3 | 0.208 | 0.398 | 62.5 |
| 4 | 0.128 | 0.398 | 71.4 |
| 5 | 0.080 | 0.398 | 83.3 |
| 6 | 0.050 | 0.398 | 100.0 |
| 7 | 0.029 | 0.398 | 125.0 |
| 8 | 0.015 | 0.398 | 166.7 |
| 9 | 0.007 | 0.398 | 250.0 |
| 10 | 0.002 | 0.398 | 500.0 |

# FIG.7

| n | Input Capacitor $C_n$(pf) | Inductance $L_n$(nH) | Characteristic Impedance of Artificial Input Transmission Line $Z_n$($\Omega$) |
|---|---|---|---|
| 1 | 0.779 | 0.398 | 50.0 |
| 2 | 0.429 | 0.421 | 55.6 |
| 3 | 0.275 | 0.452 | 62.5 |
| 4 | 0.188 | 0.494 | 71.4 |
| 5 | 0.132 | 0.553 | 83.3 |
| 6 | 0.093 | 0.637 | 100.0 |
| 7 | 0.065 | 0.765 | 125.0 |
| 8 | 0.043 | 0.982 | 166.7 |
| 9 | 0.026 | 1.421 | 250.0 |
| 10 | 0.012 | 2.744 | 500.0 |

# FIG.8

| n | Input Capacitor $C_n$(pf) | Inductance $L_n$(nH) | Characteristic Impedance of Artificial Input Transmission Line $Z_n(\Omega)$ | Cutoff Frequency of Artificial Input Transmission Line (GHz) |
|---|---|---|---|---|
| 1 | 0.779 | 0.398 | 50.0 | 20.0 |
| 2 | 0.363 | 0.398 | 55.6 | 22.2 |
| 3 | 0.208 | 0.398 | 62.5 | 25.0 |
| 4 | 0.128 | 0.398 | 71.4 | 28.6 |
| 5 | 0.080 | 0.398 | 83.3 | 33.3 |
| 6 | 0.050 | 0.398 | 100.0 | 40.0 |
| 7 | 0.029 | 0.398 | 125.0 | 50.0 |
| 8 | 0.015 | 0.398 | 166.7 | 66.7 |
| 9 | 0.007 | 0.398 | 250.0 | 100.0 |
| 10 | 0.002 | 0.398 | 500.0 | 200.0 |

# FIG.9

| n | Input Capacitor $C_n$(pf) | Inductance $L_n$(nH) | Characteristic Impedance of Artificial Input Transmission Line $Z_n(\Omega)$ | Cutoff Frequency of Artificial Input Transmission Line (GHz) |
|---|---|---|---|---|
| 1 | 0.779 | 0.398 | 50.0 | 20.0 |
| 2 | 0.505 | 0.442 | 55.6 | 20.0 |
| 3 | 0.350 | 0.497 | 62.5 | 20.0 |
| 4 | 0.252 | 0.568 | 71.4 | 20.0 |
| 5 | 0.183 | 0.663 | 83.3 | 20.0 |
| 6 | 0.132 | 0.796 | 100.0 | 20.0 |
| 7 | 0.093 | 0.995 | 125.0 | 20.0 |
| 8 | 0.063 | 1.326 | 166.7 | 20.0 |
| 9 | 0.038 | 1.989 | 250.0 | 20.0 |
| 10 | 0.017 | 3.979 | 500.0 | 20.0 |

# FIG.10

| n | Input Capacitor $C_n$(pf) | Inductance $L_n$(nH) |
|---|---|---|
| 1 | 0.779 | 0.398 |
| 2 | 0.363 | 0.398 |
| 3 | 0.208 | 0.398 |
| 4 | 0.128 | 0.398 |
| 5 | 0.080 | 0.398 |
| 6 | 0.050 | 0.398 |
| 7 | 0.029 | 0.398 |
| 8 | 0.015 | 0.398 |
| 9 | 0.007 | 0.398 |
| 10 | 0.002 | 0.398 |

# FIG.11

| n | Input Capacitor $C_n$(pf) | Inductance $L_n$(nH) |
|---|---|---|
| 1 | 0.779 | 0.199 |
| 2 | 0.505 | 0.221 |
| 3 | 0.350 | 0.249 |
| 4 | 0.252 | 0.284 |
| 5 | 0.183 | 0.332 |
| 6 | 0.132 | 0.398 |
| 7 | 0.093 | 0.497 |
| 8 | 0.063 | 0.663 |
| 9 | 0.038 | 0.995 |
| 10 | 0.017 | 1.989 |

FIG.12

EP 2 993 784 A1

# FIG.13

| n | Input Capacitor $C_n$(pf) | Inductance $L_n$(nH) | Characteristic Impedance of Artificial Input Transmission Line $Z_n(\Omega)$ | Combined Capacitance (pf) |
|---|---|---|---|---|
| 1 | 0.339 | 0.398 | 50.0 | 0.159 |
| 2 | 0.363 | 0.398 | 55.6 | 0.129 |
| 3 | 0.208 | 0.398 | 62.5 | 0.102 |
| 4 | 0.128 | 0.398 | 71.4 | 0.078 |
| 5 | 0.080 | 0.398 | 83.3 | 0.057 |
| 6 | 0.050 | 0.398 | 100.0 | 0.040 |
| 7 | 0.029 | 0.398 | 125.0 | 0.025 |
| 8 | 0.015 | 0.398 | 166.7 | 0.014 |
| 9 | 0.007 | 0.398 | 250.0 | 0.006 |
| 10 | 0.002 | 0.398 | 500.0 | 0.002 |

# FIG.14

| n | Input Capacitor $C_n$(pf) | Inductance $L_n$(nH) | Characteristic Impedance of Artificial Input Transmission Line $Z_n(\Omega)$ | Combined Capacitance (pf) |
|---|---|---|---|---|
| 1 | 0.339 | 0.398 | 50.0 | 0.159 |
| 2 | 0.429 | 0.421 | 55.6 | 0.136 |
| 3 | 0.275 | 0.452 | 62.5 | 0.116 |
| 4 | 0.188 | 0.494 | 71.4 | 0.097 |
| 5 | 0.132 | 0.553 | 83.3 | 0.080 |
| 6 | 0.093 | 0.637 | 100.0 | 0.064 |
| 7 | 0.065 | 0.765 | 125.0 | 0.049 |
| 8 | 0.043 | 0.982 | 166.7 | 0.035 |
| 9 | 0.026 | 1.421 | 250.0 | 0.023 |
| 10 | 0.012 | 2.744 | 500.0 | 0.011 |

# FIG.15

| n | Input Capacitor $C_n$(pf) | Inductance $L_n$(nH) | Characteristic Impedance of Artificial Input Transmission Line $Z_n$($\Omega$) |
|---|---|---|---|
| 1 | 0.587 | 0.398 | 50.0 |
| 2 | 0.293 | 0.398 | 55.6 |
| 3 | 0.170 | 0.398 | 62.5 |
| 4 | 0.103 | 0.398 | 71.4 |
| 5 | 0.062 | 0.398 | 83.3 |
| 6 | 0.035 | 0.398 | 100.0 |
| 7 | 0.017 | 0.398 | 125.0 |
| 8 | 0.004 | 0.398 | 166.7 |
| 9 | -0.004 | 0.398 | 250.0 |
| 10 | -0.008 | 0.398 | 500.0 |

# FIG.16

| n | Input Capacitor $C_n$(pf) | Inductance $L_n$(nH) | Characteristic Impedance of Artificial Input Transmission Line $Z_n$($\Omega$) |
|---|---|---|---|
| 1 | 0.587 | 0.398 | 50.0 |
| 2 | 0.399 | 0.442 | 55.6 |
| 3 | 0.284 | 0.497 | 62.5 |
| 4 | 0.206 | 0.568 | 71.4 |
| 5 | 0.149 | 0.663 | 83.3 |
| 6 | 0.107 | 0.796 | 100.0 |
| 7 | 0.073 | 0.995 | 125.0 |
| 8 | 0.047 | 1.326 | 166.7 |
| 9 | 0.025 | 1.989 | 250.0 |
| 10 | 0.006 | 3.979 | 500.0 |

FIG.17

FIG.18

## INTERNATIONAL SEARCH REPORT

| International application No. |
| --- |
| PCT/JP2014/060018 |

**A. CLASSIFICATION OF SUBJECT MATTER**
*H03F3/60*(2006.01)i, *H03F1/48*(2006.01)i

According to International Patent Classification (IPC) or to both national classification and IPC

**B. FIELDS SEARCHED**

Minimum documentation searched (classification system followed by classification symbols)
H03F1/00-3/72

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 60-233912 A (Raytheon Co.), 20 November 1985 (20.11.1985), entire text; all drawings & US 4543535 A & GB 2157908 A & GB 8509751 A0 & DE 3513659 A & FR 2563065 A | 1-12 |
| A | US 4864250 A (Peter Bacon), 05 September 1989 (05.09.1989), column 4, line 67 to column 6, line 10; fig. 4 to 5 (Family: none) | 1-12 |

☒ Further documents are listed in the continuation of Box C.　　　☐ See patent family annex.

| | | |
| --- | --- | --- |
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| 17 June, 2014 (17.06.14) | 01 July, 2014 (01.07.14) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**INTERNATIONAL SEARCH REPORT**

International application No.

PCT/JP2014/060018

C (Continuation).   DOCUMENTS CONSIDERED TO BE RELEVANT

| Category* | Citation of document, with indication, where appropriate, of the relevant passages | Relevant to claim No. |
|---|---|---|
| A | JP 61-140211 A  (Nippon Telegraph and Telephone Corp.), 27 June 1986 (27.06.1986), page 5, lower left column, line 4 to page 8, upper left column, line 17; fig. 3 to 9 (Family: none) | 1-12 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. MASUDA ; A. AKASEGAWA ; T. OHKI ; K. MAKIYAMA ; N. OKAMOTO ; K. IMANISHI ; T. KIKKAWA ; H. SHIGEMATSU.** Over 10W C-Ku Band GaN MMIC Non-uniform Distributed Power Amplifier with Broadband Couplers. *IEEE MTT Symp,* May 2010, 1388-1391